**Europäisches Patentamt**

**European Patent Office**

**Office européen des brevets**

(19)

(11) Veröffentlichungsnummer: **0 200 863**
**B1**

(12) # EUROPÄISCHE PATENTSCHRIFT

(45) Veröffentlichungstag der Patentschrift:
**23.08.89**

(51) Int. Cl.⁴: **H01L 29/743, H01L 29/06**

(21) Anmeldenummer: **86102558.3**

(22) Anmeldetag: **27.02.86**

(54) Halbleiterbauelement mit Thyristor- und Diodenstrukturen.

(30) Priorität: **20.03.85  CH 1237/85**

(43) Veröffentlichungstag der Anmeldung:
**17.12.86 Patentblatt 86/46**

(45) Bekanntmachung des Hinweises auf die Patenterteilung:
**23.08.89 Patentblatt 89/34**

(84) Benannte Vertragsstaaten:
**BE CH DE FR GB IT LI SE**

(56) Entgegenhaltungen:
**EP-A- 0 015 835**
**DE-A- 2 406 431**
**DE-A- 3 336 979**
**GB-A- 2 030 796**
**US-A- 4 296 427**
**US-A- 4 357 621**

(73) Patentinhaber: **BBC Brown Boveri AG, Haselstrasse,
CH-5401 Baden(CH)**

(72) Erfinder: **Jaecklin, André, Dr., Geissbergstrasse 55,
CH-5400 Ennetbaden(CH)**

**Beschreibung**

Bei der Erfindung wird ausgegangen von einem Halbleiterbauelement nach dem Oberbegriff des Patentanspruchs 1.

Mit diesem Oberbegriff nimmt die Erfindung auf einen Stand der Technik Bezug, wie er in der CH-PS 594 989 beschrieben ist. Dort ist ein rückwärtsleitender Thyristor angegeben, der einen Thyristor und eine antiparallele Diode auf einer Siliziumscheibe vereinigt. Die gegenseitige Beeinflussung der beiden Komponenten wird durch spezielle Schutzringe im Bauelement vermieden.

Derartige rückwärtsleitende Thyristoren werden in der Leistungselektronik für Gleichstromsteller, Umrichter, unterbrechungsfreie Stromversorgungsanlagen, Elektrofilter usw. verwendet, vgl. die Schweizer Firmenzeitschrift Brown Boveri Mitteilungen 1 (1979), S. 5 - 10. In allen Fällen, in denen eine induktive Last, z. B. ein Motor auf dem Gebiet der Traktion, angesteuert wird, ist ein Strompfad in Gegenrichtung zur Durchlassrichtung des Thyristors vorzusehen. Nachteilig dabei ist, dass konventionelle Thyristoren in zwangskommutierten Schaltungen zum Abschalten eine Kommutierungsschaltung erfordern.

Aus Hitachi Review, Vol. 31 (1982) No. 1, S. 23 - 27 ist es bekannt, ausschaltbare, d.h. GTO (Gate Turn-Off)-Thyristoren anstelle der konventionellen Thyristoren einzusetzen.

GTO-Thyristoren sind in einem sehr breiten Bereich von Ausschaltströmen (20 A ... > 2000 A) und Spannungen (600 V ... > 4500 V) erhältlich, vgl. IEEE Transaction on Electron Devices, Vol. ED-31, No. 12, Dez. 1984, S. 1681 - 1686.

Wird ein GTO-Thyristor antiparallel zu einer separaten Diode geschaltet, so treten folgende Probleme auf:
- die Streuinduktivität des äusseren Kreises führt zu Ueberspannungen, die für den GTO-Thyristor schädlich sein können,
- die Diode muss hinsichtlich ihrer Kenndaten an den GTO-Thyristor angepasst sein, was nur in wenigen Fällen garantiert werden kann,
- die Kosten sind relativ hoch.

Die Erfindung, wie sie in den Patentansprüchen 1 und 6 definiert ist, löst die Aufgabe, einen GTO-Thyristor mit einer antiparallelen Diode in einem Bauelement zu vereinigen und den Steuerstrom des GTO-Thyristors möglichst gut von der Diode zu entkoppeln.

Ein Vorteil der Erfindung besteht darin, dass für den Anwender geringere Kosten resultieren. Die Kosten für ein integriertes Element sind geringer als jene für Thyristor und Diode separat. Montagekosten für eine separate Diode entfallen. Durch die Entkopplung von GTO-Thyristor und Diode wird ein Kathodenkurzschluss vermieden. Gleichzeitig wird gewährleistet, dass während der Leitphase der Diode nur wenige freie Ladungsträger in den Bereich des GTO-Thyristors gelangen, so dass dort Fehlzündungen, die zu einer Zerstörung des Bauelements führen könnten, vermieden werden.

Die Erfindung wird nachstehend anhand von Ausführungsbeispielen erläutert.

Es zeigen:

Fig. 1 ein scheibenförmiges, rotationssymmetrisches Halbleiterbauelement in Draufsicht,

Fig. 2 einen Querschnitt durch einen Teil des Halbleiterbauelements gemäss Fig. 1 längs der Linie A,

Fig. 3, 4, 6 Querschnitte durch Teile von Halbleiterbauelementen in speziellen Ausbildungen,

Fig. 5 und 7 spezielle Ausbildungen einer Schutzzone zwischen Diode und GTO-Thyristor gemäss Fig. 4 bzw. 6.

In den Figuren sind gleiche Teile mit gleichen Bezugszeichen gekennzeichnet.

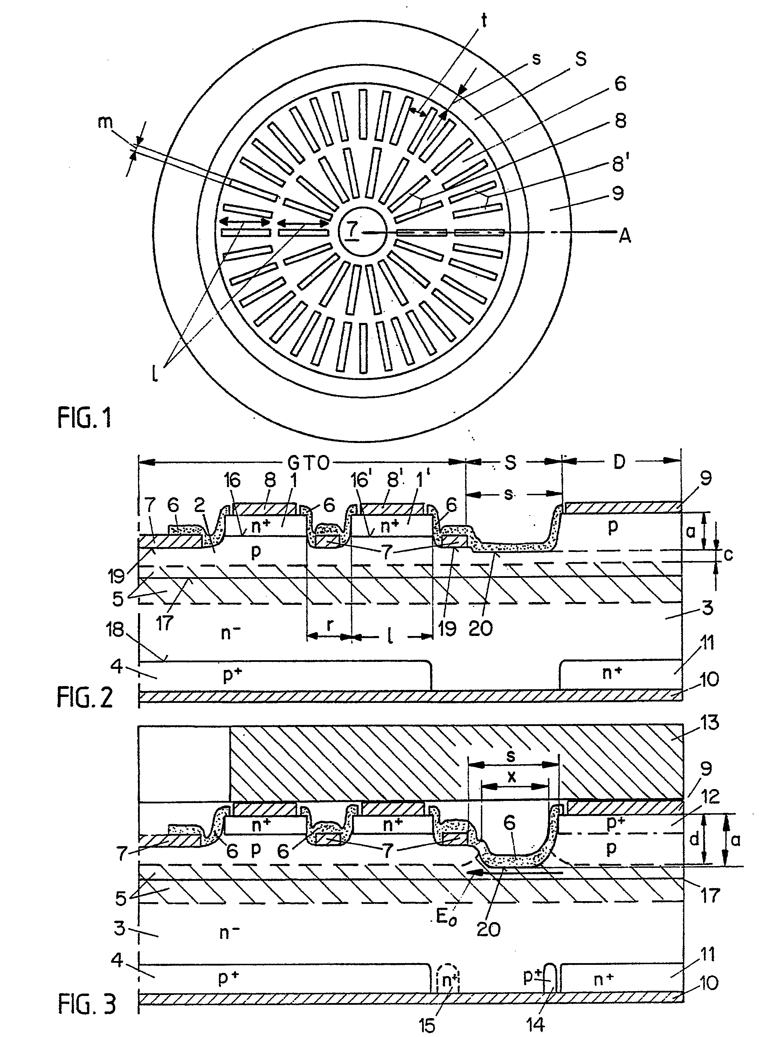

Die in Fig. 1 nicht massstabsgerecht dargestellte, kreisförmige Halbleiterscheibe weist im Zentrum eine GTO-Steuerelektrode 7 umgeben von einer inerten, elektrisch isolierenden Passivierungsschicht 6 auf, die eine hohe elektrische Feldstärke aushält. Als Passivierungsmaterial wird Polyimid verwendet. Aus dieser Passivierungsschicht 6 ragen in zwei konzentrischen Zonen inselartig zahlreiche längliche GTO-Kathodenelektroden 8 und 8' heraus. Die Länge 1 der GTO-Kathodenelektroden 8 und 8' liegt im Bereich von 2 mm ... 8 mm, deren Breite m im Bereich von 100 μm ... 500 μm, vorzugsweise im Bereich von 200 μm ... 400 μm. Der mittlere Abstand t in Kreisumfangsrichtung benachbarter GTO-Kathodenelektroden 8 bzw. 8' liegt im Bereich von 0,3 mm ... 0,5 mm. Der radiale Abstand r zwischen den GTO-Kathodenelektroden 8 und 8', vgl. Fig. 2, liegt im Bereich von 100 μm ... 1 mm, vorzugsweise im Bereich von 300 μm ... 500 μm.

Längs des Aussenumfangs der Halbleiterscheibe befindet sich eine Elektrode 9 einer Dioden-Anode. Zwischen der Elektrode 9 und dem Bereich des GTO-Thyristors befindet sich eine Schutzzone S der Breite s von typischerweise mindestens zwei Trägerdiffusionslängen. Diese Breite s ist so gross zu wählen, dass während der Leitphase der Diode D nur eine geringe Zahl freier Ladungsträger in den Bereich des GTO-Thyristors gelangen. Der radiale Abstand der GTO-Kathodenelektroden 8' von der Schutzzone S liegt im Bereich von 10 μm ... 1 mm, vorzugsweise im Bereich von 100 μm ... 300 μm.

Die Halbleiterscheibe hat einen Durchmesser, je nach der geforderten maximalen Ausschaltstromstärke, im Bereich von 10 mm ... 100 mm und eine Dicke, je nach geforderter Sperrspannung, im Bereich von 200 μm ... 1,5 mm.

Der in Fig. 2 schematisch dargestellte Querschnitt längs der Linie A in Fig. 1 von der Mitte der Halbleiterscheibe bis zu deren rechtem Rand zeigt im linken Teil einen mit GTO bezeichneten Bereich zweier ausschaltbarer Thyristoren, kurz GTO-Bereich genannt, der über die Schutzzone S mit dem Diodenbereich D im rechten Teil in Verbindung steht.

Der GTO-Bereich weist für jeden Thyristor 4 Ladungsträgerschichten abwechselnden Leitungstyps n und p auf, und zwar für jeden Thyristor eine separate hochdotierte n-leitende Emitterschicht bzw. eine $n^+$-Emitterschicht 1 bzw. 1' als GTO-Kathodenschicht mit einer Donatorenkonzentration an der Oberfläche im Bereich von $10^{19}$ cm$^{-3}$ ... $10^{21}$ cm$^{-3}$, eine für beide Thyristoren gemeinsame mitteldotierte p-leitende p-Basisschicht 2 mit einer Akzeptorenkonzentration an der Oberfläche im Bereich von $10^{17}$ cm$^{-3}$ ... $10^{19}$ cm$^{-3}$, eine für beide Thyristoren gemeinsame niedrigdotierte, n-leitende n$^-$-Basisschicht 3 mit einer Donatorenkonzentration im Bereich von $10^{13}$ cm$^{-3}$ ... $10^{15}$ cm$^{-3}$ und eine gemeinsame hochdotierte, p-leitende p$^+$-Emitterschicht 4 als GTO-Anodenschicht mit einer Akzeptorenkonzentration im Bereich von $10^{18}$ cm$^{-3}$ ... $10^{20}$ cm$^{-3}$ an der Oberfläche.

Ein erster pn-Uebergang zwischen der n$^+$-Emitterschicht 1, 1' und der p-Basisschicht 2 ist mit 16 bezeichnet, ein zweiter pn-Uebergang zwischen der p-Basisschicht 2 und der n$^-$-Basisschicht 3 mit 17 und ein dritter pn-Uebergang zwischen der n$^-$-Basisschicht 3 und der p$^+$-Emitterschicht 4 mit 18. Eine Raumladungszone zu beiden Seiten des zweiten pn-Uebergangs 17 ist mit 5 bezeichnet. Mit 7 ist eine bezüglich der n$^+$-Emitterschichten 1 und 1' vertieft liegende Steuerelektrode bezeichnet, welche mit Abstand die GTO-Kathodenelektroden 8 und 8' umgibt. Die Oberfläche 19 des von der Steuerelektrodenschicht 7 überdeckten und kontaktierten Steuerelektrodenbereiches liegt tiefer als der erste pn-Uebergang 16.

Die p-Basisschicht 2 und die n$^-$-Basisschicht 3 erstrecken sich vom Thyristorbereich GTO über die Schutzzone S in den Diodenbereich D. Die p-Basisschicht 2 bildet dort die Anode der Diode D, welche eine Elektrodenschicht 9 trägt, die auf gleicher Höhe mit den GTO-Kathodenelektroden 8 und 8' liegt. Die n$^-$-Basisschicht 3 grenzt im Diodenbereich D an eine hochdotierte n-leitende n$^+$-Diodenschicht", welche die Diodenkathode bildet. Sowohl die p$^+$-Emitterschicht 4 des GTO als auch die n$^-$-Basisschicht 3 im Bereich der Schutzzone S und die n$^+$-Diodenschicht 11 weisen an ihrer Aussenfläche gleiches Niveau auf und sind durch eine allen gemeinsame Metallschicht 10, welche eine erste Hauptelektrode des Halbleiterbauelements bildet, elektrisch kontaktiert.

Alle Elektroden bzw. Elektrodenschichten bestehen aus Aluminium. Selbstverständlich sind zur elektrischen Kontaktierung auch andere Metalle wie Gold, Platin, usw. geeignet.

Zwischen der GTO-Steuerelektrodenschicht 7 und den GTO-Kathodenelektroden 8 und 8' sowie der Elektrode 9 der Dioden-Anode ist die Passivierungsschicht 6 aufgebracht. Diese Passivierungsschicht 6 kann die Steuerelektrodenschicht 7, bis auf einen zentralen, für den elektrischen Anschluss vorgesehenen Bereich, überdecken, nicht jedoch die GTO-Kathodenelektroden 8 und 8' sowie die Elektrode 9, da sonst deren gemeinsame elektrische Kontaktierung mit einer als zweite Hauptelektrode dienenden Molybdänschicht 13, vgl. Fig. 3, nicht garantiert wäre. Die Passivierungsschicht 6 kann sicherheitshalber zu den GTO-Kathodenelektroden 8 und 8' sowie zu der Elektrode 9 einen kleinen Abstand aufweisen. Eine Passivierung der Oberfläche 20 im Bereich der Schutzzone ist beim Ausführungsbeispiel der Fig. 2 im Prinzip nicht erforderlich.

Die grösste Tiefe a der Aussparung der Schutzzone S von der Oberfläche der GTO-Kathodenschicht 1 und 1' liegt im Bereich von 10 μm ... 100 μm. Die Oberfläche 20 des Schutzzonenbereiches S liegt etwas tiefer als die Oberfläche 19 des angrenzenden Steuerelektrodenbereiches. Die Raumladungszone 5 hat von der Oberfläche 20 einen Abstand c im Bereich von 1 μm ... 30 μm, vorzugsweise von 1 μm ... 10 μm, so dass sie an keinem Punkt der Schutzzone S diese Oberfläche 20 erreicht.

Durch Einbau von Schwermetallatomen wie Gold oder Platin in das Siliziumgrundmaterial des Halbleiterbauelements oder durch Elektronen- oder Gammabestrahlung ist die Ladungsträgerlebensdauer in der Diode vorzugsweise kürzer eingestellt als im Thyristor.

Zur besseren Entkopplung von Diode D und Thyristor GTO können im Bereich der Schutzzone S mit geringem Abstand angrenzend an die n$^+$-Diodenschicht 11 und vorzugsweise auch an die p$^+$-Emitterschicht 4 ein p$^+$-Schutzring 14 und ein n$^+$-Schutzring 15 angebracht sein, wie bei der Ausgestaltung gemäss Fig. 3, siehe dort. Wichtig ist, dass die Breite s der Schutzzone S und die durch Aetzen erzeugte Tiefe a der Aussparung der Schutzzone S so gross sind, dass ein unerwünschter Stromanteil von der Steuerelektrodenschicht 7 zur Dioden-Anode beim Zünd- und Löschvorgang des GTO-Thyristors vernachlässigbar klein bleibt.

Eine weitere Verbesserung der Entkopplung von Diode D und GTO-Thyristor wird durch das in Fig. 3 im Querschnitt teilweise dargestellte Halbleiterbauelement erreicht. Hier ist die Raumladungszone 5 längs einer Teilbreite x der Schutzzone S bis an deren Oberfläche 20 geführt, wobei der Abstand d der ungestörten Raumladungszone 5 von der Oberfläche der GTO-Kathodenschicht 1 und 1' bzw. von der Oberfläche einer p$^+$-Diodenschicht 12 kleiner ist als die maximale Tiefe a der Aussparung der Schutzzone S. Die Differenz a - d liegt im Bereich von 1 μm - 30 μm, vorzugsweise im Bereich von 1 μm - 10 μm. Die Teilbreite x ist annähernd so gross wie die Breite s der Schutzzone S.

Die im Vergleich zu Fig. 2 tiefere Ausnehmung im Bereich der Schutzzone S wird nach der letzten Hochtemperaturbehandlung des Halbleiterbauelements vorzugsweise durch Aetzen erzeugt.

Der zweite pn-Uebergang 17 befindet sich genügend weit unterhalb der tiefstgelegenen Oberfläche 20 des Schutzzonenbereiches, so dass die Feldstärke $E_0$ unterhalb dieser Oberfläche 20 $< 10^5$ V/cm, vorzugsweise $< 2 \cdot 10^4$ V/cm ist.

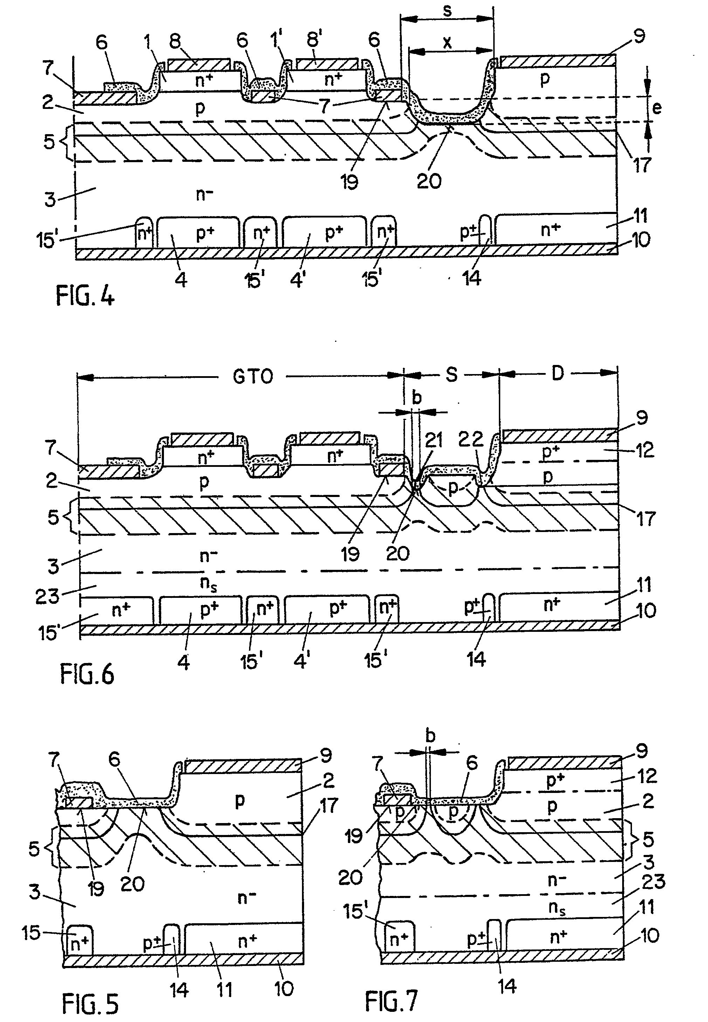

Bei dieser Ausbildung sowie bei den Ausbildungen des Halbleiterbauelements gemäss den Fig. 4 - 7 ist eine Passivierung durch eine Passivierungsschicht 6 im Bereich der Schutzzone S erforderlich.

Während des Zündvorgangs des GTO-Thyristors wird durch diese Ausgestaltung des Halbleiterbauelements ein parasitärer Steuerelektrodenstrom blockiert. Während des Hauptteiles des Löschvorganges ist ein leitfähiger Kanal vorhanden. Als Nebeneffekt resultiert eine um wenige Prozent reduzierte Sperrspannung des Halbleiterbauelements. Im Diodenbereich kann durch die p$^+$-Schicht 12 als Dioden-Anode zwischen der p-Basisschicht 2 und der Elektrode 9 eine verbesserte Ladungsträgerinjektion erreicht werden.

Bei der Ausgestaltung des Halbleiterbauelements gemäss Fig. 4 ist der zweite pn-Uebergang 17 im Bereich der Schutzzone S an deren tiefstgelegene Oberfläche 20 geführt. Diese Oberfläche 20 liegt um eine Zusatztiefe bzw. um einen Abstand e im Bereich von 1 μm ... 50 μm, vorzugsweise im Bereich von 1 μm ... 20 μm tiefer als die Oberfläche 19 des Steuerelektrodenbereiches.

Erreicht wird diese Ausbildung des Halbleiterbauelements durch eine homogene Einbringung von Akzeptoren wie Bor, Aluminium oder Gallium in den oberen Bereich der Siliziumscheibe, die später die p-Basisschicht 2 erzeugen soll. Danach wird über die Teilbreite x der Schutzzone S die p-Basisschicht 2 z.B. durch Aetzen abgetragen. Anschliessend wird getempert. Beim Tempern erfolgt eine thermische Diffusion der Akzeptoren der p-Basisschicht, wodurch die gewünschte Tiefe des pn-Ueberganges 17 eingestellt wird. Da im Bereich der Aussparung der Schutzzone S die Akzeptoren entfernt worden sind, wölbt sich der zweite pn-Uebergang 17 und die Raumladungszone 5 am Rand der Schutzzone nach oben. Durch anschliessende Aetzung wird die Oberfläche im Steuer-Bereich des GTO-Thyristors und vorzugsweise auch in der Schutzzone mindestens um die Dicke der n⁺-Emitterschicht 1 bzw. 1' auf die Höhe der Oberfläche 19 abgesenkt. Die Teilbreite x der Schutzzone S liegt im Bereich von 0,1 mm ... 1 mm. Für grosse Werte von x ist eine sehr gute Passivierung im Bereich der Schutzzone erforderlich, da die maximale Feldstärke $E_0 \approx 10^5$ V/cm erreichen kann.

Beim Zündvorgang wird ein parasitärer Steuerelektrodenstrom blockiert; beim Löschvorgang wirkt die Schutzzone S wie ein lateraler pnp-Transistor ohne Basisstrom, der einen parasitären Steuerelektrodenstrom blockiert. Als Nebeneffekt resultiert bei grosser Teilbreite x allerdings eine starke Verringerung der Sperrspannung.

Im Anodenbereich des GTO-Thyristors ist die p⁺-Emitterschicht im Steuerelektrodenbereich durch n⁺-Anodenkurzschlusszonen 15' unterbrochen, die das Ausschalten des Thyristors erleichtern.

Diese Anodenkurzschlüsse übernehmen die Funktion des Schutzringes 15 in Fig. 3.

Die Ausbildung des Halbleiterbauelements gemäss Fig. 5 unterscheidet sich von derjenigen der Fig. 4 dadurch, dass sich die Oberfläche 19 im Steuerelektrodenbereich mit der Oberfläche 20 in der Schutzzone S auf gleicher Höhe befindet und der zweite pn-Uebergang 17 sowie die Raumladungszone 5 im Bereich der Schutzzone stärker deformiert sind. Dies wird durch eine im Bereich der Schutzzone S maskierte Einbringung von Akzeptoren in die p-Basisschicht 2 und Wegfall des ersten Aetzvorganges erreicht.

Bei der Ausbildung des Halbleiterbauelements gemäss Fig. 6 ist unterhalb der n⁻-Basisschicht 3 eine schwachdotierte n_s-Basisschicht 23 mit einer Donatorenkonzentration im Bereich von $10^{14}$ cm⁻³ ... $10^{16}$ cm⁻³ vorgesehen. Im Bereich der Schutzzone S sind der zweite pn-Uebergang 17 und die Raumladungszone 5 an einer ersten und zweiten Schutzzonenkontaktstelle 21 und 22 jeweils gleicher Breite b an dessen tiefste Oberfläche 20 geführt. Die Breite b hängt von der lateralen Diffusion ab, sie liegt im Bereich bis zu 300 μm, vorzugsweise im Bereich bis zu 100 μm. Nur im Kontaktbereich der Raumladungszone 5 ist die Oberfläche 20 tieferliegend als die Oberfläche 19 des Steuerelektrodenbereiches, so dass zwischen den Schutzzonenkontaktstellen 21 und 22 ein Teil der p-Basisschicht 2 bis an die Oberfläche der Schutzzone S reicht. Erreicht wird diese Ausbildung durch das im Zusammenhang mit Fig. 4 beschriebene Verfahren, wobei jedoch der erste Abtrag (z.B. durch Aetzen) auf die beiden Schutzzonenkontaktstellen 21 und 22 beschränkt ist.

Der Aufbau der Diodenstruktur entspricht derjenigen von Fig. 3. Die n⁺-Anodenkurzschlusszone 15' im zentralen Bereich des Halbleiterbauelements ist verbreitert gegenüber demjenigen gemäss Fig. 4 und erstreckt sich über den Durchmesser des zentralen Teils der Steuerelektrode 7.

Die Ausbildung des Halbleiterbauelements gemäss Fig. 7 unterscheidet sich von derjenigen gemäss Fig. 6 dadurch, dass sich die Oberfläche 19 im Steuerelektrodenbereich mit der Oberfläche 20 in der Schutzzone S auf gleicher Höhe befindet. Erreicht wird dies wieder wie bei der Ausbildung gemäss Fig. 5 durch maskierte Einbringung der Akzeptoren in die p-Basisschicht 2 und Weglassen des ersten Aetzvorganges.

Anstelle von zwei Schutzzonenkontaktstellen 21 und 22 können auch noch mehrere vorgesehen sein, sie wirken ähnlich wie die aus: Journal of the Japan Society of Applied Physics, Vol. 43, 1974, S. 395 - 400 bekannte Schutzringstruktur.

Beim Zündvorgang wird ein parasitärer Steuerelektrodenstrom blockiert. Beim Löschvorgang entspricht die Schutzzone mehreren lateralen, in Reihe geschalteten pnp-Transistoren ohne Basisstrom, die einen parasitären Steuerelektrodenstrom blockieren. Von Vorteil ist es, dass die Schutzzonenbreite $s \leq 1$ mm gehalten werden kann, so dass nur wenig Halbleiterfläche verloren ist für die Leitung eines elektrischen Stromes. Im Bereich der Schutzzone bleibt die Feldstärke $E_0 \approx 10^4$ V/cm, d.h. die Anforderungen an die Passivierungsschicht 6 sind bescheiden.

Eine Reduktion der Sperrspannung von nur ca. 10 % ist erreichbar. Dies kann erwünscht sein, da damit ein gezielter Spannungsdurchbruch unter der Oberfläche erreicht wird, was einer integrierten Schutzfunktion und somit erhöhter Robustheit entspricht.

Es versteht sich, dass anstelle des Diodenbereiches D deren mehrere auf demselben Halbleiterbauelement vorgesehen sein können. Anstelle der in Fig. 1 dargestellten zwei kreisförmigen Zonen mit GTO-Thyristoren können auch drei oder mehr Kreisringzonen mit GTO-Thyristoren vorgesehen sein. Der Halbleiterkörper kann quadratische oder andere Gestalt aufweisen. Die Schutzzone S kann zusätzlich Aussparungen oder Gräben aufweisen. Wichtig ist, dass die Thyristor- und Diodenbereiche gut voneinander entkoppelt sind, so dass nur wenig Ladungsträger in die jeweils anderen Bereiche überwechseln können.

**Patentansprüche**

1. Halbleiterbauelement
a) mit mindestens einer Thyristorstruktur,
b) die mindestens vier Ladungsträgerschichten (1 - 4) abwechselnden ersten Leitungstyps (n) und zweiten Leitungstyps (p) aufweist,
c) von denen eine erste äussere Ladungsträgerschicht eine Kathode (1, 1') und
d) eine zweite äussere Ladungsträgerschicht eine Anode (4, 4') bilden,
e) mit einer Steuerelektrode (7) an einer ersten inneren Ladungsträgerschicht (2), die längs einer ersten Schichtseite an die erste äussere Ladungsträgerschicht angrenzt und mit dieser einen ersten pn-Übergang (16) bildet,
f) mit einer zweiten inneren Ladungsträgerschicht (3), die an eine zweite Schichtseite der ersten inneren Ladungsträgerschicht angrenzt und mit dieser einen zweiten pn-Übergang (17) bildet,
g) mit mindestens einer aus Abschnitten der ersten inneren Ladungsträgerschicht (2) und der zweiten inneren Ladungsträgerschicht (3) gebildetn Diodenstruktur (D),
h) die von dieser mindestens einen Thyristorstruktur durch eine Schutzzone (S) lateral beabstandet ist, und
i) mit einer Raumladungszone (5) beidseits des zweiten pn-Uebergangs (17) von der ersten inneren Ladungsträgerschicht (2) zu der zweiten inneren Ladungsträgerschicht (3), die sich von dem Bereich der Thyristorstruktur bis in den Bereich der Diodenstruktur erstreckt,
dadurch gekennzeichnet,
j) dass die Thyristorstruktur die Struktur eines ausschaltbaren Thyristors (GTO) aufweist,
k) dass die Raumladungszone (5) längs des zweiten pn-Uebergangs (17) im Bereich der Schutzzone (S) an die kathodenseitige erste Oberfläche (20) dieser Schutzzone geführt ist und
l) dass die erste Oberfläche der Schutzzone mit einer Passivierungsschicht (6) überzogen ist.

2. Halbleiterbauelement nach Anspruch 1, dadurch gekennzeichnet, dass der zweite pn-Uebergang (17) an mindestens einer Schutzzonenkontaktstelle (21, 22) an die erste Oberfläche (20) der Schutzzone (S) geführt ist.

3. Halbleiterbauelement nach Anspruch 2, dadurch gekennzeichnet,
a) dass der zweite pn-Uebergang (17) an zwei Schutzzonenkontaktstellen (21, 22) an die erste Oberfläche (20) der Schutzzone (S) geführt ist,
b) dass die Breite (b) der Schutzzonenkontaktstelle (21, 22) im Bereich bis zu 300 µm liegt,
c) insbesondere, dass diese Breite (b) im Bereich bis zu 100 µm liegt.

4. Halbleiterbauelement nach Anspruch 3, dadurch gekennzeichnet, dass zwischen den beiden Schutzzonenkontaktstellen (21, 22) längs eines Teilbereichs der ersten Oberfläche (20) der Schutzzone (S) die Raumladungszone (5) von dieser ersten Oberfläche (20) beabstandet ist.

5. Halbleiterbauelement nach Anspruch 1, dadurch gekennzeichnet,
a) dass der zweite pn-Uebergang (17) so tief unterhalb der ersten Oberfläche (20) der Schutzzone (S) liegt, dass die Feldstärke (E₀) zumindest über eine Teilbreite (x) der Schutzzone < 10⁵ V/cm ist, wobei die Teilbreite annähernd gleich der gesamten Breite (s) der Schutzzone ist,
b) insbesondere, dass die Feldstärke < 2•10⁴ V/cm ist.

6. Halbleiterbauelement mit den Merkmalen a) bis i) des Patentanspruchs 1, dadurch gekennzeichnet,
j) dass die Thyristorstruktur die Struktur eines ausschaltbaren Thyristors (GTO) aufweist und
k) dass die kathodenseitige erste Oberfläche (20) der Schutzzone (S) von der Raumladungszone (5) längs des zweiten pn-Uebergangs (17) einen Abstand (c) im Bereich von 1 µm ... 30 µm aufweist.

7. Halbleiterbauelement nach einem der Ansprüche 1 bis 6, dadurch gekennzeichnet,
a) dass die erste Oberfläche (20) der Schutzzone (S) bezüglich der ersten äusseren Ladungsträgerschicht (1, 1') des Thyristors mindestens ebenso tief liegt wie die Oberfläche (19) eines Steuerelektrodenbereiches, auf dem die Steuerelektrode (7) aufgebracht ist, und
b) dass mindestens ein Steuerelektrodenbereich an die Schutzzone (S) lateral angrenzt.

8. Halbleiterbauelement nach einem der Ansprüche 1 bis 7, dadurch gekennzeichnet, dass eine Vertiefung (a) der ersten Oberfläche (20) der Schutzzone (S) bezüglich der ersten äußeren Ladungsträgerschicht (1, 1') im Bereich von 10 µm ... 100 µm vorgesehen ist.

9. Halbleiterbauelement nach einem der Ansprüche 1 bis 8, dadurch gekennzeichnet,
a) dass zumindest im Bereich zwischen einer Steuerelektrode (7) und der benachbarten ersten Ladungsträgerschicht (1, 1') eine Passivierungsschicht (6) vorgesehen ist,
b) insbesondere, dass die Passivierungsschicht Polyimid enthält.

10. Halbleiterbauelement nach einem der Ansprüche 1 bis 9, dadurch gekennzeichnet,
a) dass die Ladungsträgerlebensdauer im Bereich der Diodenstruktur (D) kürzer ist als im Bereich der Thyristorstruktur (GTO),
b) dass in dem anodenseitigen Bereich der Schutzzone (S), der sich zwischen einer GTO-Anode (4) und einer Dioden-Kathode (11) erstreckt, in geringem Abstand zur Dioden-Kathode (11) eine hoch p-dotierte Elektronenfangzone (14) vorgesehen ist,
c) insbesondere, dass im anodenseitigen im Bereich der Schutzzone (S) in geringem Abstand zur GTO-Anode (4) eine hoch n-dotierte Defektelektronenfangzone (15) vorgesehen ist.

**Claims**

1. Semiconducter component
a) comprising at least one thyristor structure,
b) which has at least four charge carrier layers (1–4) of alternating first type of conduction (n) and second type of conduction (p),
c) a first outer charge carrier layer of which forms a cathode (1, 1') and

d) a second outer charge carrier layer forms an anode (4, 4'),

e) comprising a gate electrode (7) at a first inner charge carrier layer (2) which adjoins the first outer charge carrier layer along a first layer side and forms with this a first pn junction (16),

f) comprising a second inner charge carrier layer (3) which adjoins a second layer side of the first inner charge carrier layer and forms with this a second pn junction (17),

g) comprising at least one diode structure (D), formed from sections from the first inner charge carrier layer (2) and the second inner charge carrier layer (3),

h) which is laterally spaced apart from this at least one thyristor structure by a protective zone (S) and

i) comprising a space charge zone (5) on both sides of the second pn junction (17) between the first inner charge carrier layer (2) and the second inner charge carrier layer (3) which extends from the region of the thyristor structure into the region of the diode structure, characterized in that

j) the thyristor structure has the structure of a gate turn-off thyristor (GTO),

k) the space charge zone (5) is carried along the second pn junction (17) in the region of the protective zone (S) to the cathode-side first surface (20) of this protective zone and

l) the first surface of the protective zone is covered with a passivation layer (6).

2. Semiconductor component according to Claim 1, characterized in that the second pn junction (17) is carried to the first surface (20) of the protective zone (S) at at least one protective zone contact point (21, 22).

3. Semiconductor component according to Claim 2, characterized in that

a) the second pn junction (17) is carried to the first surface (20) of the protective zone (S) at two protective zone contact points (21, 22),

b) the width (b) of the protective zone contact point (21, 22) is within a range of up to 300μm,

c) particularly, this width (b) is within a range of up to 100μm.

4. Semiconductor component according to Claim 3, characterized in that between the two protective zone contact points (21, 22) along a part region of the first surface (20) of the protective zone (S), the space charge zone (5) is spaced apart from this first surface (20).

5. Semiconductor component according to Claim 1, characterized in that

a) the second pn junction (17) lies low enough below the first surface (20) of the protective zone (S) for the field strength ($E_0$) to be $< 10^5$ V/cm at least over a part width (x) of the protective zone, the part width being approximately equal to the total width (s) of the protective zone,

b) particularly, the field strength is $< 2 \times 10^4$ V/cm.

6. Semiconductor component having the features a) to i) of Claim 1, characterized in that

j) the thyristor structure has the structure of a gate turn-off thyristor (GTO) and

k) the cathode-side first surface (20) of the protective zone (5) has a distance (c) within a range of 1 μm . . . 30 μm from the space charge zone (5) along the second pn junction (17).

7. Semiconductor component according to one of Claims 1 to 6, characterized in that

a) the first surface (20) of the protective zone (S) is at least as deep with respect to the first outer charge carrier layer (1,1') of the thyristor as the surface (19) of a gate electrode region to which the gate electrode (7) is attached, and

b) at least one gate electrode region laterally adjoins the protective zone (S).

8. Semiconductor component according to one of Claims 1 to 7, characterized in that an indentation (a) of the first surface (20) of the protective zone (5) with respect to the first outer charge carrier layer (1, 1') is provided within a range of 10 μm . . . 100 μm.

9. Semiconductor component according to one of Claims 1 to 8, characterized in that

a) a passivation layer (6) is provided at least in the region between a gate electrode (7) and the adjacent first charge carrier layer (1, 1'),

b) particularly, that the passivation layer contains polyimide.

10. Semiconductor component according to one of Claims 1 to 9, characterized in that

a) the life of the charge carriers is shorter in the region of the diode structure (D) than in the region of the thyristor structure (GTO),

b) a highly p-doped electron capture zone (14) is provided at a small distance from the diode cathode (11) in the anode-side region of the protective zone (s) which extends between a GTO anode (4) and a diode cathode (11), particularly, a highly n-doped hole capture zone (15) is provided at a small distance from the GTO anode (4) in the anode-side region of the protective zone (S).

**Revendications**

1. Elément semi-conducteur:

a) comportant au moins une structure de thyristor;

b) qui comprend au moins quatre couches à porteurs de charge (1–4) en alternance d'un premier type de conduction (n) et d'un second type de conduction (p);

c) parmi lesquelles une première couche à porteurs de charge extérieure forme une cathode (1, 1'), et

d) une seconde couche à porteurs de charge extérieure forme une anode (4, 4');

e) comportant une électrode de commande (7) à une première couche à porteurs de charge intérieure (2), qui est adjacente le long d'un premier côté de couche à la première couche à porteurs de charge extérieure et forme avec celle-ci une première jonction pn (16);

f) comportant une seconde couche à porteurs de charge intérieure (3) qui est adjacente à un second côté de couche de la première couche à porteurs de charge intérieure et forme avec celle-ci une deuxième jonction pn (17);

g) comportant au moins une structure de diode (D) formée de sections de la première couche à porteurs de charge intérieure (2) et de la deuxième couche à porteurs de charge intérieure (3);

h) qui est espacée latéralement de cette structure de thyristor au moins unique par une zone de protection (S), et

i) comportant une zone de charge d'espace (5) de part et d'autre de la seconde jonction pn (17) à partir de la première couche à porteurs de charge intérieure (2) vers la seconde couche à porteurs de charge, intérieure (3) qui s'étend depuis le domaine de la structure de thyristor jusque dans le domaine de la structure de diode, caractérisé en ce que:

j) la structure de thyristor présente la structure d'un thyristor à extinction (GTO);

k) la zone de charge d'espace (5) est amenée le long de la seconde jonction pn (17) dans le domaine de la zone de protection (S) à la première surface (20) située du côté cathode de cette zone de protection, et

l) la première surface de la zone de protection est recouverte d'une couche de passivation (6).

2. Elément semi-conducteur suivant la revendication 1, caractérisé en ce que la seconde jonction pn (17) est amenée à au moins un endroit de contact de zone de protection (21, 22) à la première surface (20) de la zone de protection (S).

3. Elément semi-conducteur suivant la revendication 2, caractérisé en ce que:

a) la seconde jonction pn (17) est amenée à deux endroits de contact de zone de protection (21, 22) à la première surface (20) de la zone de protection (S);

b) la largeur (b) de l'endroit de contact de zone de protection (21, 22) tombe dans le domaine allant jusqu'à 300 $\mu$m;

c) en particulier, cette largeur (b) tombe dans le domaine allant jusqu'à 100 $\mu$m.

4. Elément semi-conducteur suivant la revendication 3, caractérisé en ce qu'entre les deux endroits de contact de zone de protection (21, 22), le long d'un domaine partiel de la première surface (20) de la zone de protection (S), la zone de charge d'espace (5) est espacée de cette première surface (20).

5. Elément semi-conducteur suivant la revendication 1, caractérisé en ce que:

a) la seconde jonction pn (17) est disposée si profondément en dessous de la première surface (20) de la zone de protection (S) que l'intensité de champ ($E_0$), au moins au-dessous d'une largeur partielle (x) de la zone de protection, est inférieure à $10^5$ V/cm, la largeur partielle étant approximativement égale à la largeur totale (s) de la zone de protection;

b) plus particulièrement, l'intensité de champ est inférieure à $2 \times 10^4$ V/cm.

6. Elément semi-conducteur présentant les particularités a) à i) de la revendication 1, caractérisé en ce que:

j) la structure de thyristor présente la structure d'un thyristor à extinction (GTO), et

k) la première surface (20) du côté cathode de la zone de protection (S) présente une distance (c) comprise entre 1 et 30 $\mu$m de la zone de charge d'espace (5) le long de la seconde jonction pn (17).

7. Elément semi-conducteur suivant l'une quelconque des revendications 1 à 6, caractérisé en ce que:

a) la première surface (20) de la zone de protection (S) est disposée, par rapport à la première couche à porteurs de charge extérieure (1, 1') du thyristor, au moins aussi profondément que la surface (19) d'un domaine d'électrode de commande sur lequel l'électrode de commande (7) est disposée, et

b) au moins un domaine d'électrode de commande est latéralement adjacent à la zone de protection (S).

8. Elément semi-conducteur suivant l'une quelconque des revendications 1 à 7, caractérisé en ce qu'un creux (a) de la première surface (20) de la zone de protection (S), compris entre 10 et 100 $\mu$m par rapport à la première couche à porteurs de charge extérieure (1, 1'), est prévu.

9. Elément semi-conducteur suivant l'une quelconque des revendications 1 à 8, caractérisé en ce que:

a) au moins dans le domaine situé entre une électrode de commande (7) et la première couche à porteurs de charge voisine (1, 1') est prévue une couche de passivation (6);

b) en particulier, la couche de passivation contient un polyimide.

10. Elément semi-conducteur suivant l'une quelconque des revendications 1 à 9, caractérisé en ce que:

a) la durée de vie des porteurs de charge est plus courte dans le domaine de la structure de diode (D) que dans le domaine de la structure de thyristor (GTO);

b) dans le domaine situé du côté anode de la zone de protection (s), que s'étend entre une anode GTO (4) et une cathode de diode (11), est prévue une zone de capture d'électrons de type p (14) fortement dopée;

c) en particulier, dans le domaine du côté anode de la zone de protection (S), à courte distance de l'anode GTO (4), est prévue une zone de capture de lacunes-trous de type n (15) fortement dopée.

EP 0 200 863 B1

FIG.1

FIG.2

FIG.3

FIG. 4

FIG. 6

FIG. 5

FIG.7